# EUROPEAN PATENT SPECIFICATION

(11) **EP 1 647 036 B1**
(45) Date of publication and mention of the grant of the patent: **21.11.2007**
(21) Application number: 04737200.8
(22) Date of filing: 28.06.2004
(51) Int. Cl.: H01F 17/02

(54) **INDUCTIVE-SYSTEM**
INDUKTIVES SYSTEM
SYSTEME INDUCTIF

(30) Priority: 11.07.2003 EP 03102113
(43) Date of publication of application: 19.04.2006
(73) Proprietor: NXP B.V., 5656 AG Eindhoven (NL)
(72) Inventor: LIM, Kui Yong, Weisshausstrasse 2 52066 Aachen (DE); LEE, Su Hwei, Weisshausstrasse 2 52066 Aachen (DE)
(74) Representative: White, Andrew Gordon
(86) International application number: PCT/IB2004/051021
(87) International publication number: WO 2005/006357

(56) References cited:
- US-A1- 2002 142 512
- US-B1- 6 463 875
- HUNG C-M ET AL: "A PACKAGED 1.1-GHZ CMOS VCO WITH PHASE NOISE OF -126 DBC/HZ AT A 600-KHZ OFFSET" IEEE JOURNAL OF SOLID-STATE CIRCUITS, IEEE INC. NEW YORK, US, vol. 35, no. 1, January 2000 (2000-01), pages 100-103, XP000950394 ISSN: 0018-9200
- PATENT ABSTRACTS OF JAPAN vol. 1996, no. 06, 28 June 1996 (1996-06-28) & JP 8 046424 A (MATSUSHITA ELECTRIC IND CO LTD), 16 February 1996 (1996-02-16)

## Description

The invention relates to an inductive-system, to a printed circuit board comprising an inductive-system, to a tuner comprising a filter with an inductive-system, and to a method for producing an inductive- system.

An example of such an inductive-system is a coil, a chip inductor etc. The tuner for example forms part of a television receiver.

A prior art inductive-system is known from US 6,163,300, which discloses in its Fig. 2 a chip inductor, in its Fig. 6 a helical coil, and in its Fig. 17- 19 pattern coils

From US 2002/0142512 a microelectronic fabrication comprising: a substrate; a spirally patterned conductor layer formed over the substrate, wherein the spirally patterned conductor layer terminates in a microelectronic structure formed within the center of the spirally patterned conductor layer, wherein the spirally patterned conductor layer forms a planar spiral inductor, and wherein the microelectronic structure formed within the center of the spirally patterned conductor layer comprises a series of electrically interconnected sub- patterns is known.

In tuners in television receivers, inductive-systems having relatively large inductive-values are required. When realising such a relatively large inductive value through a helical coil mounted on a printed circuit board' this helical coil gets a relatively large physical size. This leaves less room for the other components on the printed circuit board, or the printed circuit board must be made relatively large in size. When realising such a relatively large inductive-value through a pattern coil printed in the printed circuit board, this pattern coil gets a relatively large physical size. This leaves less room for the other prints in the printed circuit board, or the printed circuit board must be made relatively large in size.

The known inductive-system is disadvantageous, inter alia, due to, for relatively large inductive-values, getting relatively large in size.

It is an object of the invention, inter alia, of providing an inductive system, which, for relatively large inductive-values, is relatively small in size.

Furthers objects of the invention are, inter alia, providing a printed circuit board comprising an inductive-system which, for relatively large inductive values, is relatively small in size, providing a tuner comprising a filter with an inductive-system which, for relatively large inductive-values, is relatively small in size, and providing a method for producing an inductive- system which, for relatively large inductive-values, is relatively small in size.

The inductive-system according to the invention comprises - a first part in the form of a printed coil comprising a number of turns defined by at least one track width and at least one turn spacing; and - a second part in the form of a non-printed coil; which printed coil and which non-printed coil are coupled serially.

By serially coupling the printed coil (like for example a pattern coil etc.) and the non-printed coil (like for example a chip inductor etc.), the inductive-values of both coils are to be added, resulting in the inductive- system getting a relatively large inductive-value. So, both coils are coupled serially for making the inductive-value of the inductive-system larger than each inductive-value of each individual coil. Due to the first part being printed and therefore being located in a printed circuit board and the second part being non-printed and therefore being mounted on the printed circuit board, the inductive-system uses the available room efficiently, and is relatively small in size.

It should be noted that US 6,307440 B1 discloses an inductive-system with a pattern coil in a printed circuit board and an air-core coil mounted on the printed circuit board. However, these coils are coupled in parallel, to adjust an oscillation frequency of an oscillator circuit by adjusting an angle of the air-core coil relative to the printed circuit board. Both coils each comprise half a turn or more and less than one turn and are therefore not defined by at least one turn spacing, because a turn spacing requires a coil to have more than one turn. So, this inductive- system does not comprise serially coupled coils and is not designed, adapted or arranged for making the inductive- value of the inductive- system larger than an individual inductive-value of an individual coil.

A first embodiment of the inductive-system according to the invention is defined by claim 1. By realising the non-printed coil through an air coil comprising a further number of turns defined by at least one wire diameter and at least one coil diameter, the non-printed coil can be coupled magnetically to a further component and/or to a further part of the printed circuit board.

A second embodiment of the inductive-system according to the invention is deemed by claim 2. The total inductance of the inductive-system is substantially equal to an inductance of the printed coil plus an inductance of the air coil plus a mutual inductance. So, the inductive-value of the inductive- system can be made larger than the sum of the inductive-values of both coils, dependently on the sign of the mutual inductance.

A third embodiment of the inductive-system according to the invention is defined by claim 3. The value of the mutual inductance can be chosen by combining a right turn air coil or a left turn air coil with a clockwise printed coil or an anti-clockwise printed coil and by selecting a length of the air coil, and increases with the length of the air coil until a maximum overlapping area between the printed coil and the air coil has been reached.

A fourth embodiment of the inductive-system according to the invention is defined by claim 4. The number of turns are farther defined by a diameter of a center path and a turning direction (clockwise or anti-clockwise), with the further number of turns being further defined by a turning orientation (right turn or left turn) to create more design options.

A fifth embodiment of the inductive-system according to the invention is defined by claim 5. With one end of the non-printed coil being coupled to a center end of the printed coil and with the other end of the non-printed coil and an outer end of the printed coil constituting ends of the inductive-system, both coils are coupled in a compact way.

A sixth embodiment of the inductive-system according to the invention is defined by claim 6. The printed coil can be printed on an inner or an outer layer of a printed circuit board, to create more design options, and with the kind of layer used being of little influence to the functioning of the inductive-system.

The printed coil can be cylindrical, rectangular, hexagonal etc. and the air coil can be cylindrical, rectangular, hexagonal etc. without departing from the scope of this invention. So, the word "turn" may be a kind of circular turn, a kind of rectangular turn, a kind of hexagonal turn etc.

Embodiments of the printed circuit board according to the invention, of the tuner according to the invention and of the method according to the invention correspond with the embodiments of the inductive-system according to the invention.

The invention is based upon an insight, inter alia, that large printed coils and large non-printed coils are to be avoided, and is based upon a basic idea, inter alia, that both kinds of coils can be combined efficiently by coupling them serially.

The invention solves the problem, inter alia, of providing an inductive-system which, for relatively large inductive-values, is relatively small in size, and is advantageous, inter alia, in that the available room is used efficiently.

These and other aspects of the invention will be apparent from and elucidated with reference to the embodiments(s) described hereinafter.

In the drawings:

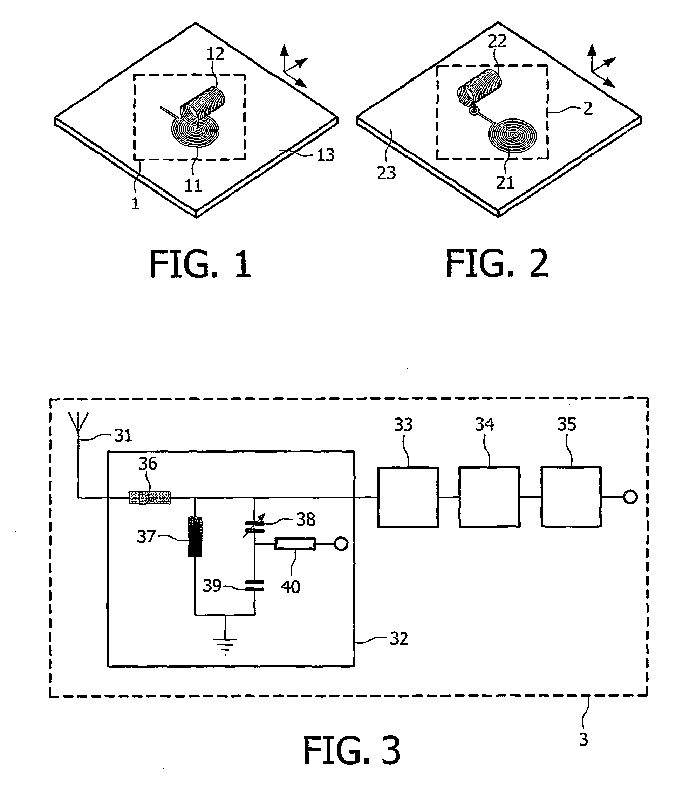

Fig. 1 shows in block diagram form an inductive-system according to the invention;
Fig. 2 shows in block diagram form another inductive-system according to the invention;
Fig. 3 shows in block diagram form a tuner according to the invention; and

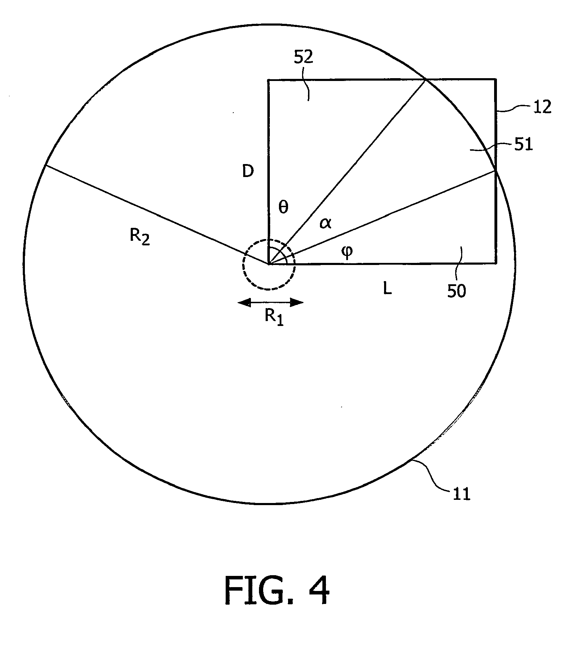

Fig. 4 shows in schematical form a top view of a printed coil and an air coil.

The inductive-system 1 according to the invention shown in Fig. 1 comprises a printed coil 11 printed on a printed circuit board 13, and an air coil 12 mounted on the printed circuit board 13. Both coils 11,12 are coupled serially, with one end of the air coil 12 being coupled to a center end of the printed coil 11 and with the other end of the air coil 12 and the outer end of the printed coil 11 forming the ends of the inductive-system 1.

The inductive-system 2 according to the invention shown in Fig. 2 comprises a printed coil 21 printed on a printed circuit board 23, and an air coil 22 mounted on the printed circuit board 23. Both coils 21,22 are coupled serially, with one end of the air coil 22 being coupled to an outer end of the printed coil 21 and with the other end of the air coil 22 and the inner end of the printed coil 21 forming the ends of the inductive-system 2.

The tuner 3 according to the invention shown in Fig. 3 comprises an antenna input 31 to be coupled to an antenna or a cable or a satellite receiver etc. Antenna input 31 is coupled to an input of a filter 32, of which an output is coupled to an input of an amplifier 33, of which an output is coupled to an input of a bandpass filter 34, of which an output is coupled to an input of a mixer 35 etc. Filter 32 comprises a coil 36 coupled between the input and the output of the filter 32. Filter 32 further comprises a coil 37 coupled between the output of filter 32 and ground, and a serial circuit coupled in parallel to coil 37 and comprising a variable capacitor 38 and a capacitor 39. The common point of this serial circuit is coupled via a resistor 40 to a control input for receiving a control voltage for adjusting the variable capacitor 38 for tuning purposes. Each one of coils 36 and 37 may correspond with the inductive-system 1 or 2 as shown in Fig 1 or 2. Bandpass filter 34 may also comprise an inductive-system 1 or 2.

The top view of a printed coil 11 and an air coil 12 as shown in Fig. 4 comprises the printed coil 11 having a radius (R₂) and the air coil 12 having a coil diameter (D) and a length (L). An overlapping area 50,51,52 comprises a first triangle 50 having a surface area equal to 0.5•L•R₂•sin (ϕ), a circle segment 51 having a surface area equal to 0.5• (R₂)²•α, and a second triangle 52 having a surface area equal to 0.5•D• R₂•sin (θ).

The printed coil 11 comprises a number (n) of turns defined by at least one track width (w) and at least one turn spacing (s). The air coil 12 comprises a further number (T) of turns defined by at least one wire diameter (W) and at least one coil diameter (D). The number (n) of turns are further defined by a diameter of a center path (R₁) and a turning direction (d being clockwise or counterclockwise); with the further number (T) of turns being further defined by a turning orientation (O being left or right). The diameter of the center path (R₁) corresponds with a diameter of a most inner path, with the radius (R₂) corresponding with half the diameter of a most outer path. A total inductance of the inductive-system 1 is substantially equal to an inductance of the printed coil 11 plus an inductance of the air coil 12 plus a mutual inductance. The value of the mutual inductance is chosen by combining a right turn air coil or a left turn air coil with a clockwise printed coil or an counterclockwise printed coil and by selecting a length (L) of the air coil 12, with the mutual inductance increasing with the length (L) of the air coil 12 until a maximum overlapping area (50,51,52) between the printed coil 11 and the air coil 12 has been reached. The mutual inductance is relatively large negative for right turn air coils 12 combined with clockwise printed coils 11, and for left turn air coils 12 combined with counterclockwise printed coils 11. For other combinations of air coils and printed coils, the mutual inductance is slightly negative for air coils having a relatively low number of turns (T) and increasingly positive for air coils having an increasing number of turns (T). The mutual inductance is relatively independent from the kind of layer (inner layer or outer layer) used for the printed coil 11.

The inductive value of the printed coil 11 should be at most for example 1/3 of the inductive value of the inductive-system 1, to avoid that spreading in printed circuit board factors like etching accuracy and dielectric constant etc. get too much influence. When used in a 100 MHz region, the air coil 12 may have an inductance of about 200 nH and a Quality factor Q of about 100, the printed coil 11 may have an inductance of about 150 nH and a Quality factor Q of about 65, with the inductive-system having an inductance of about 350 nH and a Quality factor Q of about 84.

The printed coil 11,21 can be cylindrical, rectangular, hexagonal etc. and the air coil 12,22 can be cylindrical, rectangular, hexagonal etc. without departing from the scope of this invention. So, the word "turn" may be a kind of circular turn, a kind of rectangular turn, a kind of hexagonal turn etc.

The expression "for" in for example "for A" and "for B" does not exclude that other functions "for C" are performed as well, simultaneously or not. The expressions "X coupled to Y" and "a coupling between X and Y" and "coupling/couples X and Y" etc. do not exclude that an element Z is in between X and Y. The expressions "P comprises Q" and "P comprising Q" etc. do not exclude that an element R is comprised/included as well.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "to comprise" and its conjugations does not exclude the presence of elements or steps other than those stated in a claim. The article "a" or "an" preceding an element does not exclude the presence of a plurality of such elements. The mere fact that certain measures are recited in mutually different dependent claims does not indicate that a combination of these measures cannot be used to advantage.

The invention is based upon an insight, inter alia, that large printed coils and large non-printed coils are to be avoided, and is based upon a basic idea, inter alia, that both kinds of coils can be combined efficiently by coupling them serially.

The invention solves the problem, inter alia, of providing an inductive-system which, for relatively large inductive-values, is relatively small in size, and is advantageous, inter alia, in that the available room is used efficiently.

## Claims

1. Inductive-system (1,2) comprising - a first part in the form of a printed coil (11,21) comprising a number of turns defined by at least one track width and at least one turn spacing; and - a second part in the form of a non-printed coil (12,22); which printed coil (11,21) and which non-printed coil (12,22) are coupled serially, wherein the non- printed coil (12,22) comprises an air coil comprising a further number of turns defined by at least one wire diameter and at least one coil diameter (D).

2. Inductive-system (12) as defined in claim 2, wherein a total inductance I of the inductive-system (1,2) is substantially equal to an inductance ofthe printed coil (11,21) plus an inductance of the air coil plus a mutual inductance.

3. Inductive-system (1,2) as defined in claim 3, wherein a value of the I mutual inductance has been chosen by combining a right turn air coil or a left turn air coil with a clockwise printed coil or an anti-clockwise printed coil and by selecting a length (L) of the air coil, with the mutual inductance increasing with the length (L) of the air coil until a maximum overlapping area (50,51,52) between the printed coil (11,21) and the air coil has been reached.

4. Inductive-system (1,2) as defined in claim 2, wherein the number of turns are further deemed by a diameter of a center path (Rat) and a turning direction, with the further number of turns being further deemed by a turning orientation.

5. Inductive-system (1) as defined in claim 1, wherein one end ofthe non- printed coil (12) is coupled to a center end of the printed coil (11), with the other end of the non-printed coil (12) and an outer end ofthe printed coil (11) constituting ends ofthe inductive-system (1).

6. Inductive-system (1,2) as defined in claim 1, wherein the printed coil (11,21) is printed on an inner or an outer layer of a printed circuit board (13,23).

7. Printed circuit board (13,23) which comprises an inductive-system (1, 2) according to claim 1 and printed coil (11,21) is printed on an inner or outer layer of the printed circuit wherein the board (13,23).

8. Tuner (3) which comprises a filter (32) with an inductive-system (1, 2) according to claim 1.

9. Method for producing an inductive-system (1,2) and comprising the steps of - producing a first part in the form of a printed coil (11,21) comprising a number of turns defined by at least one track width and at least one turn spacing; producing a second part in the form of a non-printed coil (12, 22); and - coupling the printed coil (11,21) and the non-printed coil (12,22) serially, wherein the non- printed coil (12,22) comprises an air coil comprising a further number of turns defined by at least one wire diameter and at least one coil diameter (D).

## Patentansprüche

1. Induktives System (1, 2) mit
- einem ersten Teil in der Form einer gedruckten Spule (11, 21), die eine Anzahl von Windungen aufweist, die durch mindestens eine Bahnbreite und mindestens einen Windungsabstand definiert sind, und
- einem zweiten Teil in der Form einer nicht-gedruckten Spule (12, 22),
- welche gedruckte Spule (11, 21) und welche nicht-gedruckte Spule (12, 22) in Serie geschaltet sind,
- wobei die nicht-gedruckte Spule (12, 22) eine Luftspule enthält, die eine weitere Anzahl von Windungen aufweist, die durch mindestens einen Drahtdurchmesser und mindestens einen Spulendurchmesser (D) definiert sind.

2. Induktives System (1, 2) nach Anspruch 1, wobei eine Gesamtinduktivität I des induktiven Systems (1, 2) im Wesentlichen gleich einer Induktivität der gedruckten Spule (11, 21) zuzüglich einer Induktivität der Luftspule zuzüglich einer Gegeninduktivität ist.

3. Induktives System (1, 2) nach Anspruch 2, wobei ein Wert der Gegeninduktivität durch Kombinieren einer rechts-gewickelten Luftspule oder einer links-gewickelten Luftspule mit einer im Uhrzeigersinn gedruckten Spule oder einer entgegen dem Uhrzeigersinn gedruckten Spule und durch Auswahl einer Länge (L) der Luftspule bestimmt wird, wobei die Gegeninduktivität mit der Länge (L) der Luftspule zunimmt, bis eine maximale Überlappungsfläche (50, 51, 52) zwischen der gedruckten Spule (11, 21) und der Luftspule erreicht wird.

4. Induktives System (1, 2) nach Anspruch 1, wobei die Anzahl von Windungen weiter durch einen Durchmesser eines inneren Pfades (R₁) und einer Wicklungsrichtung definiert ist, wobei die weitere Anzahl von Windungen weiter durch eine Wicklungsorientierung definiert ist.

5. Induktives System (1) nach Anspruch 1, wobei ein Ende der nicht-gedruckten Spule (12) mit einem mittleren Ende der gedruckten Spule (11) verbunden ist, während das andere Ende der nicht-gedruckten Spule (12) und ein äußeres Ende der gedruckten Spule (11) die Anschlüsse des induktiven Systems (1) bilden.

6. Induktives System (1, 2) nach Anspruch 1, wobei die gedruckte Spule (11, 21) auf eine innere oder eine äußere Schicht einer gedruckten Schaltungsplatine (13, 23) gedruckt ist.

7. Gedruckte Schaltungsplatine (13, 23), die ein induktives System (1, 2) nach Anspruch 1 enthält und bei der eine gedruckte Spule (11, 21) auf eine innere oder eine äußere Schicht der gedruckten Schaltungsplatine (13, 23) gedruckt ist.

8. Abstimmschaltung (3), die ein Filter (32) mit einem induktiven System (1, 2) nach Anspruch 1 enthält.

9. Verfahren zur Herstellung eines induktiven Systems (1, 2) mit den Schritten
- Herstellung eines ersten Teils in der Form einer gedruckten Spule (11, 21), die eine Anzahl von Windungen aufweist, die durch mindestens eine Bahnbreite und mindestens einen Windungsabstand definiert sind, und
- Herstellung eines zweiten Teils in der Form einer nicht-gedruckten Spule (12, 22), und
- Verbinden der gedruckten Spule (11, 21) und der nicht-gedruckte Spule (12, 22) in Serie,
- wobei die nicht-gedruckte Spule (12, 22) eine Luftspule enthält, die eine weitere Anzahl von Windungen aufweist, die durch mindestens einen Drahtdurchmesser und mindestens einen Spulendurchmesser (D) definiert sind.

## Revendications

1. Système inductif (1, 2) comprenant
- une première partie sous la forme d'une bobine imprimée (11, 21) comprenant un certain nombre de spires défini par au moins une largeur de piste et au moins un espacement de spires ; et
- une deuxième partie sous la forme d'une bobine non imprimée (12, 22) ; ladite bobine imprimée (11, 21) et ladite bobine non imprimée (12, 22) sont couplées en séries,
dans lequel la bobine non imprimée (12, 22) comprend une bobine à air comprenant un autre nombre de spires défini par au moins un diamètre de fil et au moins un diamètre de bobine (D).

2. Système inductif (12) tel que défini dans la revendication 2, dans lequel l'inductance totale I du système inductif (1, 2) est essentiellement égale à l'inductance de la bobine imprimée (11, 21) plus l'inductance de la bobine à air plus l'inductance mutuelle.

3. Système inductif (1, 2) tel que défini dans la revendication 3, dans lequel une valeur de l'inductance mutuelle I a été choisie en combinant une bobine à air tournant à droite ou une bobine à air tournant à gauche avec une bobine imprimée tournant dans le sens des aiguilles d'une montre ou une bobine imprimée tournant dans le sens inverse des aiguilles d'une montre et en sélectionnant une longueur (L) de la bobine à air, dans laquelle l'inductance mutuelle augmente avec la longueur (L) de la bobine à air jusqu'à ce qu'une zone de superposition maximale (50, 51, 52) entre la bobine imprimée (11, 21) et la bobine à air ait été atteinte.

4. Système inductif (1, 2) tel que défini dans la revendication 2, dans lequel le nombre de spires est en outre **caractérisé par** un diamètre d'un chemin central (Rat) et par un sens d'enroulement, le nombre supplémentaire de spires étant en outre **caractérisé par** un sens d'enroulement.

5. Système inductif (1) tel que défini dans la revendication 1, dans lequel une extrémité de la bobine non imprimée (12) est couplée à une extrémité centrale de la bobine imprimée (11), l'autre extrémité de la bobine non imprimée (12) et une extrémité externe de la bobine imprimée (11) constituant les extrémités du système inductif (1).

6. Système inductif (1, 2) tel que défini dans la revendication 1, dans lequel la bobine imprimée (11, 21) est imprimée sur une couche interne ou externe d'une carte à circuit imprimé (13, 23).

7. Carte à circuit imprimé (13, 23) qui comprend un système inductif (1, 2) selon la revendication 1 et dans lequel la bobine imprimée (11, 21) est imprimée sur une couche interne ou externe de la carte à circuit imprimé (13, 23).

8. Syntoniseur (3) qui comprend un filtre (32) avec un système inductif (1, 2) selon la revendication 1.

9. Procédé de production d'un système inductif (1, 2) et comprenant les étapes de
- production d'une première partie sous la forme d'une bobine imprimée (11, 21) comprenant un certain nombre de spires défini par une largeur d'au moins une piste et un espacement d'au moins un tour; production d'une deuxième partie sous la forme d'une bobine non imprimée (12, 22); et
- couplage de la bobine imprimée (11, 21) et de la bobine non imprimée (12, 22) en séries,
dans lequel la bobine non imprimée (12, 22) comprend une bobine à air comprenant un autre nombre de spires défini par au moins un diamètre de fil et au moins un diamètre de bobine (D).
